# EUROPÄISCHE PATENTSCHRIFT

(11) **EP 2 306 535 B1**
(45) Veröffentlichungstag und Bekanntmachung des Hinweises auf die Patenterteilung: **12.11.2014**
(21) Anmeldenummer: 10178551.7
(22) Anmeldetag: 23.09.2010
(51) Int. Cl.: H01L 35/00, F24C 7/00, F24C 15/00

(54) **Hausgerät mit einer sich im Betrieb erwärmenden Komponente und einer mit elektrischer Energie zu versorgenden Einrichtung sowie Verfahren zum Versorgen einer Einrichtung eines Hausgeräts mit elektrischer Energie**
Domestic appliance with a component that heats up during operation and a device supplied with electrical energy and method for supplying a device of a domestic appliance with electrical energy
Appareil ménager doté d'un composant chauffant en fonctionnement et d'un dispositif alimenté par énergie électrique ainsi que procédé d'alimentation d'un dispositif d'appareil ménager doté d'énergie électrique

(30) Priorität: 02.10.2009 DE 102009045292
(43) Veröffentlichungstag der Anmeldung: 06.04.2011
(73) Patentinhaber: BSH Bosch und Siemens Hausgeräte GmbH, 81739 München (DE)
(72) Erfinder: Dengler, Klaus, 83471, Schönau am Königssee (DE); Hangl, Felix, 83329, Waging am See (DE); Steinbeck, Martin-Ernst, 83342 Tacherting (DE); de Vries, Markus, 83278, Traunstein (DE)

(56) Entgegenhaltungen:
- EP-A2- 0 504 555
- WO-A1-2008/142317
- WO-A1-2010/043597
- CN-Y- 201 378 816
- DE-A1-102006 023 452
- JP-A- 7 119 908
- JP-A- 11 299 289
- US-A- 6 019 098

## Beschreibung

Die Erfindung betrifft ein Hausgerät mit einer sich im Betrieb erwärmenden ersten Komponente und einer mit elektrischer Energie zu versorgenden Einrichtung, wobei das Hausgerät mit einem externen Energieversorgungsnetz verbunden ist. Des Weiteren betrifft die Erfindung ein Verfahren zum Versorgen einer Einrichtung eines Hausgeräts mit elektrischer Energie.

Hausgeräte, wie Backöfen und Elektroherde, weisen Komponenten auf, die sich im Betrieb erwärmen. In diesem Zusammenhang sind beispielsweise die Backoffenmuffel oder aber auch elektronische Komponenten und Motoren, genannt. Zur Kühlung von elektronischen Bauteilen oder Motoren werden Gebläse eingesetzt. Diese sind jedoch mit elektrischer Energie zu versorgen.

Aus der US 2009/002573 A1 sind Peltier-Elemente bekannt, die mit einer thermisch beaufschlagten Komponente verbunden sind und aufgrund einer Temperaturdifferenz elektrischen Strom erzeugen. Das Peltier-Element ist dabei mit zwei mit unterschiedlichen Temperaturen beaufschlagten Platten kontaktiert, um diese Temperaturdifferenz erzeugen zu können. Darüber hinaus ist aus der US 2008/0245352 A1 der Einsatz eines Peltier-Elements in einem Ofen, welcher mit Holz geheizt wird, bekannt. Auch wird das Peltier-Element einerseits mit einer warmen Platte und andererseits mit einer kalten Platte kontaktiert, um aufgrund dieser Temperaturdifferenz elektrischen Strom zu erzeugen. Um die Temperaturdifferenz relativ groß zu gestalten, wird die kühlere Platte des Weiteren noch mit einem Gebläse gekühlt.

DE102006023452 A1 offenbart eine Schaltungsanordnung zum Betreiben eines Peltier-Moduls einer Wärmepumpe eines Hausgeräts, welches insbesondere zur Pflege von Wäschestücken ausgebildet ist, mit einer Mehrzahl von Peltier-Elementen, wobei ein Schaltregler und ein Zwischenkreis, welcher einen Energiespeicher aufweist und mit dem Schaltregler verbunden ist, und wobei abhängig vom Betriebszustand des Peltier-Moduls eine vom Peltier-Modul erzeugte Energie in den Energiespeicher zur bedarfsabhängigen weiteren Verwendung in dem Hausgerät speicherbar ist.

Aus der nach dem Prioritätstag der vorliegenden Anmeldung veröffentlichten Druckschrift WO 2010/043597 A1 ist ein Elektrogerät bekannt, welches in einem Bereitschaftsbetrieb betrieben werden kann und vorzugsweise als Geschirrspülmaschine ausgebildet ist. Es weist Komponenten auf, welche sich im Betrieb erwärmen und somit Wärme erzeugen, die dann durch einen thermoelektrischen Generator in elektrische Energie umgewandelt wird, die dann elektrischen Verbrauchern eines Bereitschaftsmoduls zur Verfügung gestellt wird. Die elektrische Energie wird dabei in einem Speicher gespeichert.

Es ist Aufgabe der vorliegenden Erfindung, ein Hausgerät so auszugestalten, dass es energieeffizienter betrieben werden kann.

Diese Aufgabe wird durch ein Hausgerät, welches die Merkmale nach Anspruch 1 aufweist, und ein Verfahren, welches die Merkmale nach Anspruch 12 aufweist, gelöst.

Ein erfindungsgemäßes Hausgerät weist eine sich im Betrieb erwärmende erste Komponente auf. Des Weiteren weist das Hausgerät eine mit elektrischer Energie zu versorgenden Einrichtung auf. Das Hausgerät ist mit einem externen Energieversorgungsnetz, welches elektrische Energie liefert, verbunden. Das Hausgerät weist eine Energierückgewinnungsvorrichtung auf, welche mit der ersten Komponente thermisch gekoppelt ist und zur Umwandlung von Wärme der ersten Komponente in elektrische Energie ausgebildet ist. Darüber hinaus umfasst das Hausgerät eine Einrichtung als elektrischen Verbraucher des Hausgeräts, welche mit der Energierückgewinnungsvorrichtung gekoppelt ist, und welche die elektrische Energie bedarfsabhängig an die Einrichtung bereitstellt. Dadurch kann bei einem elektrisch betriebenem Hausgerät eine elektrische Energieeinsparung erreicht werden. Ferner kann praktisch ein Anteil des elektrischen Energiebedarfs des Hausgeräts im Hausgerät selbst erzeugt werden. Dieser Anteil kann darüber hinaus auch sehr dosiert und definiert an die Einrichtung zeit- und/oder mengenmäßig abgegeben werden, so dass die bedarfsgerechte Energieabgabe erfolgt und auch hier keine unnötige Energieabgabe durchgeführt wird.

Die Einrichtung ist vorzugsweise eine zweite sich im Betrieb erwärmende Komponente des Hausgeräts. Es kann jedoch auch vorgesehen sein, dass zusätzlich zu den beiden Komponenten des Hausgeräts die separate Einrichtung vorhanden ist.

Durch die Energierückgewinnungsvorrichtung wird ebenfalls der energieeffiziente Betrieb des Hausgeräts verbessert, da nicht zusätzliche externe Energie über ein Versorgungsnetz bereitgestellt werden muss, sondern dass zumindest die Einrichtung zumindest anteilig mit durch das Hausgerät selbst erzeugten elektrischen Strom versorgt werden kann.

In besonders vorteilhafter Weise ist vorgesehen, dass die Energierückgewinnungsvorrichtung als Notstromvorrichtung ausgebildet ist, durch welche, die Einrichtung mit Energie versorgt ist, wenn durch das externe Versorgungsnetz, mit welchem das Hausgerät verbunden ist, keine oder keine ausreichende Energieversorgung gegeben ist. Die Energierückgewinnungsvorrichtung arbeitet in besonders vorteilhafter Weise also dann, wenn durch das externe Versorgungsnetz eine Unterversorgung mit Energie zumindest der Einrichtung des Hausgeräts gegeben ist. Insbesondere fungiert die Energierückgewinnungsvorrichtung somit als Notstromaggregat, welches den erzeugten elektrischen Strom im Hausgerät quasi selbst erzeugt.

Besonders vorteilhaft ist dies bei einem Hausgerät, welches als Backofen ausgebildet ist und einen Pyrolysebetrieb aufweist. Gerade im Pyrolysebetrieb ist die Betriebssicherheit besonders hoch zu gewährleisten, so dass hier Energieausfälle vermieden werden müssen. Da beim Pyrolysebetrieb auch besonders hohe Temperaturen im Hausgerät auftreten, können somit durch die Funktionsweise der Energierückgewinnungsvorrichtung insbesondere wenn sie Peltier-Elemente aufweist, besonders vorteilhaft ermöglicht werden. Da beim Pyrolysebetrieb insbesondere die Muffel des Backofens besonders heiß wird, kann hier auch eine besonders intensive Wärmequelle genutzt werden, um elektrischen Strom durch die Energierückgewinnungsvorrichtung zu erzeugen und der dann bei einem möglichen Netzausfall im Pyrolysebetrieb anderen Einrichtungen zur Verfügung gestellt werden kann und der Pyrolysebetrieb fortgesetzt werden kann.

Das Hausgerät weist eine Steuereinheit auf, durch welche die Versorgung des Hausgeräts durch das Versorgungsnetz überwacht ist und durch welche die Betriebsart der Energierückgewinnungsvorrichtung steuerbar ist. Es kann also auch hier explizit vorgesehen sein, wann die Energierückgewinnungsvorrichtung betrieben werden soll und/oder wann sie Strom an eine Einrichtung oder weitere Komponenten des Hausgeräts liefern soll. Diesbezüglich kann eine spezifische Betriebsart der Energierückgewinnungsvorrichtung durch die Steuereinheit eingestellt werden.

Es kann auch vorgesehen sein, dass das Hausgerät eine Energiespeichereinheit aufweist, in welche zumindest anteilig die von der Energierückgewinnungsvorrichtung erzeugte elektrische Energie gespeichert wird.

Darüber hinaus umfasst das Hausgerät eine Kühlvorrichtung zum Kühlen zumindest einer zweiten Komponente. Die Kühlvorrichtung ist mit der ersten Komponente des Hausgeräts thermisch gekoppelt und die Kühlvorrichtung ist darüber hinaus zur Umwandlung der Wärme der ersten Komponente in elektrischen Strom und zur Umwandlung des Stroms zur Kühlung der zweiten Komponente ausgebildet. Die Kühlvorrichtung ist dahingehend ausgelegt und konzipiert, dass sie mit den beiden sich im Betrieb erwärmenden separaten Komponenten gekoppelt ist und ermöglicht durch Energieumwandlung von Wärme in Strom und von Strom in Kühlung die effektive Energienutzung. Von einer Komponente des Hausgeräts abgegebene Energie, nämlich Wärme kann somit sinnvoll umgewandelt und genutzt werden, um eine andere Komponente zu kühlen. Ein energieeffizienter Betrieb des Hausgeräts ist dadurch gegeben.

Vorzugsweise weist die Kühlvorrichtung ein erstes Peltier-Element auf, welches mit der ersten Komponente kontaktiert ist und zur Umwandlung der Wärme der ersten Komponente in elektrischen Strom betrieben ist. Gerade derartige Elemente sind sehr klein und kompakt aufgebaut und ermöglichen durch Kontaktierung mit einer wärmebeaufschlagten Komponente und der Kontaktierung anderseits mit einem kühleren Medium die Erzeugung einer Temperaturdifferenz, wobei aufgrund dieser Temperaturdifferenz und der Wirkungsweise eines derartigen Peltier-Elements ein elektrischer Strom erzeugt wird. Diese Funktionsweise ist auch durch den Seebeck-Effekt bekannt. Das Peltier-Element ist insbesondere auch mit einer gegenüber der ersten Komponente auf einem kälteren Temperaturniveau befindlichen Medium, beispielsweise einer Gehäusewand des Hausgeräts, kontaktiert, um die Temperaturdifferenz auszubilden, auf Grundlage derer der elektrische Strom erzeugt wird.

Vorzugsweise weist die Kühlvorrichtung eine Kühleinheit auf, welche durch das Anlegen des elektrischen Stroms zum Kühlen der zweiten Komponente ausgebildet ist. Es kann vorgesehen sein, dass diese Kühleinheit ein Kühlluftgebläse ist. Es kann somit vorgesehen sein, dass diese Ausgestaltung des Kühlluftgebläses mit dem ersten Peltier-Element verbunden ist und durch dieses erste Peltier-Element mit elektrischem Strom versorgt ist.

Besonders vorteilhaft ist es, wenn die Kühleinheit ein zweites Peltier-Element ist, welches mit der zweiten Komponente kontaktiert ist und welches durch Anlegen des elektrischen Stroms zur Erzeugung einer Temperaturdifferenz ausgebildet ist, durch welche die zweite Komponente kühlbar ist. Gerade eine derartige Ausgestaltung ist energiespezifisch und bauraumminimiert besonders geeignet. Das Zusammenspiel zweier Peltier-Elemente, welche invers betrieben werden und miteinander gekoppelt werden, gewährleistet durch die Wärmeumwandlung die Erzeugung elektrischen Stroms der wiederum genutzt werden kann, um das zweite Peltier-Element mit elektrischer Energie zu versorgen, wodurch dieses aufgrund seiner Auslegung und Funktionsweise eine Temperaturdifferenz generiert, die einen Kühleffekt an der zweiten Komponente erzeugt.

Vorzugsweise sind die beiden Peltier-Elemente direkt elektrisch miteinander verbunden. Dies ist besonders bauteilsparend und kompakt.

Vorzugsweise weisen die Kühlvorrichtung und die Energierückgewinnungsvorrichtung ein funktionell beiden Vorrichtungen zugeordnetes Element, insbesondere das erste Peltier-Element auf, welches zur Umwandlung der Wärme der ersten Komponente in elektrischen Strom ausgebildet ist. Der erzeugte Strom ist abhängig vom Bedarf der zu kühlenden zweiten Komponente und/oder abhängig von Betriebsphasen des Hausgeräts zumindest anteilig der Kühlvorrichtung und/oder zumindest anteilig der Energierückgewinnungsvorrichtung bereitstellbar. Dies bedeutet es kann somit sehr flexibel und situationsabhängig die erzeugte elektrische Energie zugeteilt und dosiert werden. Ist ein großer Kühlbedarf erforderlich, so kann die Energie vollständig der Kühlvorrichtung zugeteilt werden, wobei dies insbesondere dann vorteilhaft ist, wenn keine anderweitige Komponente mit Energie zwingend zu versorgen ist, und insbesondere wenn ein Netzausfall vorliegt.

Gerade dann, wenn auch das zweite Peltier-Element vorhanden ist, kann dies einerseits sowohl mit Energie versorgt werden und andererseits auch zur Kühlung einer Komponente beitragen. Grundsätzlich kann damit auch im nicht vorhandenen Notfall und somit nicht nur bei einer Notstromversorgung, die erzeugte elektrische Energie sofort für die Versorgung einer anderen Einrichtung und Komponente im Hausgerät verwendet werden.

Auch bei normaler Netzstromversorgung kann somit zumindest dieser Anteil an elektrischer Energie von extern eingespart werden.

Vorzugsweise ist das Hausgerät ein Backofen, welcher als erste Komponente eine Muffel aufweist, wobei das erste Peltier-Element an der Muffel, insbesondere außerhalb an einer Muffeldecke angeordnet ist. Dies ist eine besonders vorteilhafte Position, da im Hinblick auf die thermische Beaufschlagung des Peltier-Elements zur Stromerzeugung auch eine besonders große Temperaturdifferenz erzeugt und somit auch eine besonders große elektrische Stromgenerierung möglich ist.

Vorzugsweise ist die zu kühlende zweite Komponente ein Bedienmodul, insbesondere ein elektronischer Schaltungsträger und/oder ein Motor. Die Erfindung betrifft auch ein Verfahren zum Kühlen einer sich im Betrieb erwärmenden zweiten Komponente eines Hausgeräts, welche eine sich im Betrieb erwärmende erste Komponente aufweist, bei welchem das Kühlen mittels einer Kühlvorrichtung durchgeführt wird. Die Kühlvorrichtung wird mit der ersten Komponente thermisch gekoppelt und die Wärme der ersten Komponente wird durch die Kühlvorrichtung in elektrischen Strom umgewandelt, wobei der Strom für eine Kühleinheit der Kühlvorrichtung bereitgestellt wird und mit der Kühleinheit die zweite Komponente gekühlt wird.

Vorzugsweise wird die Kühlvorrichtung mit einem ersten Peltier-Element ausgebildet, welches mit der ersten Komponenten thermisch kontaktiert wird und zur Umwandlung der Wärme der ersten Komponente in elektrischen Strom betrieben wird, wobei die Kühleinheit ein zweites Peltier-Element ist, welches mit dem ersten Peltier-Element elektrisch verbunden und mit der zweiten Komponente kontaktiert wird und welches durch Anlegen des elektrischen Stroms eine Temperaturdifferenz erzeugt, durch welche die zweite Komponente gekühlt wird.

Insbesondere wird das erste Peltier-Element mit einer als erste Komponente ausgebildeten Muffel eines Backofens thermisch kontaktiert und durch das zweite Peltier-Element ein als zweite Komponente ausgebildetes Bedienmodul des Backofens gekühlt.

Bei einem erfindungsgemäßen Verfahren zum Versorgen einer Einrichtung eines Hausgeräts mit Energie, welches eine sich im Betrieb erwärmende erste Komponente aufweist wird das Hausgerät zur elektrischen Energieversorgung mit einem externen Versorgungsnetz verbunden. Eine Energierückgewinnungsvorrichtung des Hausgeräts wird mit der ersten Komponente thermisch gekoppelt und die Wärme der ersten Komponente wird durch die Energierückgewinnungsvorrichtung in elektrische Energie umgewandelt, wobei die Energierückgewinnungsvorrichtung mit der Einrichtung elektrisch gekoppelt wird, und die elektrische Energie der Einrichtung bedarfsabhängig zumindest an die Einrichtung bereitgestellt wird wobei die Energieversorgung des Hausgeräts durch das Versorgungsnetz durch eine Steuereinheit überwacht wird und die Betriebsart der Energierückgewinnungsvorrichtung und die bedarfsabhängige Energiebereitstellung der Energieversorgungseinrichtung durch die Steuereinheit gesteuert wird.

Vorteilhafte Ausgestaltungen des erfindungsgemäßen Hausgeräts sind als vorteilhafte Ausgestaltung des erfindungsgemäßen Verfahrens anzusehen.

Weitere Merkmale der Erfindung ergeben sich aus den Ansprüchen, den Figuren und der Figurenbeschreibung. Die vorstehend in der Beschreibung genannten Merkmale und Merkmalskombinationen als auch die in der Figurenbeschreibung und/oder in den Figuren alleine gezeigten Merkmale und Merkmalskombinationen sind nicht nur in der jeweils angegebenen Kombination, sondern auch in anderen Kombinationen oder in Alleinstellung verwendbar, ohne den Rahmen der Erfindung zu verlassen.

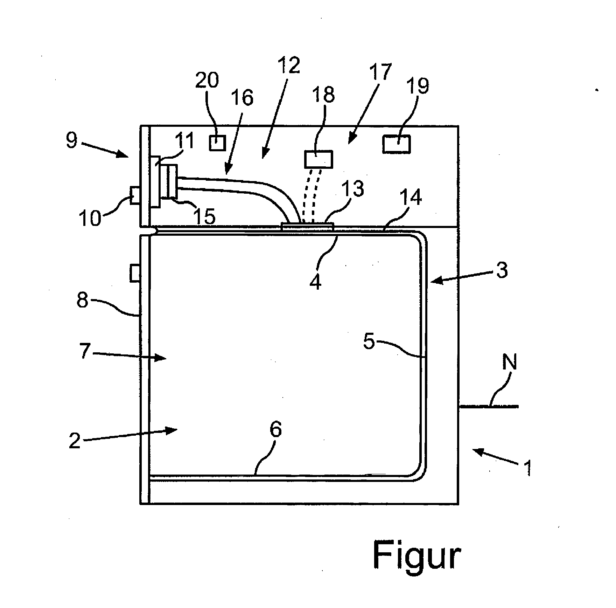

Ein Ausführungsbeispiel der Erfindung wird nachfolgend anhand einer schematischen Zeichnung näher erläutert. Die einzige Figur zeigt in vereinfachter Weise eine seitliche Schnittdarstellung durch ein Hausgerät, welches als Backofen 1 ausgebildet ist.

Der Backofen 1 weist einen Garraum 2 auf, welcher durch eine Muffel 3 begrenzt ist, wobei die Muffel 3 eine Decke 4, eine Rückwand 5 und einen Boden 6 sowie nicht weiter gekennzeichnete Seitenwände aufweist. Frontseitig ist die Muffel 3 geöffnet und weist eine Beschickungsöffnung 7 auf, welche durch eine Tür 8 verschließbar ist. Darüber hinaus umfasst der Backofen 1 ein Bedienmodul 9, welches eine Mehrzahl von Bedienelementen 10 aufweist. Über das Bedienmodul 9 können Betriebsfunktionen und Betriebsparametereinstellungen durchgeführt werden. Das Bedienmodul 9 umfasst einen Schaltungsträger 10, auf dem elektronische Bauteile angeordnet sind. Sowohl die als erste Komponente ausgebildete Muffel 3 als auch das separat dazu ausgebildete und angeordnete Bedienmodul 9, welches die zweite Komponente darstellt, sind sich im Betrieb erwärmende Komponenten.

Der Backofen 1 umfasst darüber hinaus eine Kühlvorrichtung 12, welche zum Kühlen des Bedienmoduls 9, insbesondere des Schaltungsträgers 10 ausgebildet ist. Die Kühlvorrichtung 12 umfasst ein erstes Peltier-Element 13. Dieses erste Peltier-Element 13 ist thermisch mit der Muffel 3 kontaktiert und im Ausführungsbeispiel direkt an der Außenseite 14 der Decke 4 angeordnet.

Die Kühlvorrichtung 12 umfasst darüber hinaus ein zweites Peltier-Element 15, welches in direktem thermischen Kontakt mit dem Schaltungsträger 11 angeordnet ist. Die beiden Peltier-Elemente 13 und 15 sind elektrisch miteinander verbunden und dazu über Signalleitungen 16 kontaktiert. Es kann eine direkte Verbindung vorgesehen sein, ebenso ist eine Verbindung über zwischen geschaltete elektronische Einrichtungen möglich.

Das erste Peltier-Element 13 ist so betrieben, dass es die Wärme der Muffel 3 aufnimmt und aufgrund der Temperaturdifferenz, die sich am Peltier-Element einstellt, in elektrischen Strom umwandelt. Dieser wird in einer Ausführung an dem zweiten Peltier-Element 15 zur Verfügung gestellt, welches diesen aufgrund der inversen Betriebsweise in eine Temperaturdifferenz umwandelt, und aufgrund dieser Temperaturdifferenz ein Kühlen des Schaltungsträgers 11 erzeugt wird.

Es wird somit auf einfache und effektive Weise die in dem Hausgerät selbst erzeugte Energie in Form von Wärme wiederverwendet und genutzt und insbesondere in der Kühlvorrichtung 12 dazu eingesetzt, dass eine weitere temperaturbeaufschlagte Komponente gekühlt werden kann.

Darüber hinaus umfasst der Backofen 1 eine Energierückgewinnungsvorrichtung 17. Diese umfasst ebenfalls das erste Peltier-Element 13, welches somit funktionell sowohl der Kühlvorrichtung 12 als auch der Energierückgewinnungsvorrichtung 17 zugeordnet ist.

Die Energierückgewinnungsvorrichtung 17 umfasst darüber hinaus zumindest eine Einrichtung 20, welche mit der die von dem ersten Peltier-Element 13 erzeugte elektrischen Energie in spezifischen Betriebsphasen energieversorgt wird.

Besonders vorteilhaft ist vorgesehen, dass dazu die Energierückgewinnungsvorrichtung 17 als Notstromvorrichtung betrieben wird. Gerade dann, wenn der Backofen 1, welcher mit einem externen Energieversorgungsnetz N verbunden ist und dadurch mit Energie versorgt wird, keine oder keine oder ausreichende Energieversorgung gewährleistet, kann durch diese interne Energierückgewinnungsvorrichtung 17 Strom bereitgestellt werden und ein weiterer Betrieb des Backofens 1 sichergestellt werden. Besonders vorteilhaft ist dies im Pyrolysebetrieb des Backofens 1, bei dem sehr hohe Temperaturen auftreten und bei dem ein hoher Energiebedarf erforderlich ist. Um diesen sicher durchführen zu können, auch dann, wenn beispielsweise ein Netzausfall vorliegt, wird durch diese interne Energiegewinnungsvorrichtung 17 des Backofens 1 auch solchen sicherheitskritischen Situationen Rechnung getragen und die Energieversorgung kann auch weiter aufrecht erhalten werden.

Es kann vorgesehen sein, dass der Backofen 1 einen Energiespeicher 18 aufweist, in dem die von dem Peltier-Element 13 erzeugte Energie gespeichert werden kann. So kann auch dann, wenn kein Notstrombetrieb gegeben ist, bereits elektrische Energie erzeugt und zwischengespeichert werden. Der Backofen 1 umfasst darüber hinaus eine Steuereinheit 19, mit welcher die Energieversorgung von Komponenten und das Kühlen gesteuert werden kann. Auch der in dem Energiespeicher 18 enthaltene Energieanteil kann diesbezüglich bedarfsgerecht an entsprechende Komponenteneinrichtungen abgegeben werden.

Neben der vorzugsweise vorgesehenen Ausgestaltung als Notstromvorrichtung der Energierückgewinnungsvorrichtung 17 kann darüber hinaus, wie bereits oben zur Erläuterung der Kühlvorrichtung 12 dargelegt, auch außerhalb dieses Notstrombetriebs die erzeugte elektrische Energie des ersten Peltier-Elements 13 sofort an andere Komponenten oder Einrichtungen des Backofens 1 zu deren elektrischen Energieversorgung gegeben werden.

Der von dem ersten Peltier-Element 13 erzeugte elektrische Strom kann somit abhängig vom Bedarf der zu kühlenden zweiten Komponente 9 beziehungsweise 11 und/oder abhängig von Betriebsphasen des Backofens 1 zumindest anteilig der Kühlvorrichtung 12 und/oder zumindest anteilig der Energierückgewinnungsvorrichtung 17 bereitgestellt werden. Auch für die Kühlvorrichtung 12 ist somit der von dem ersten Peltier-Element 13 erzeugte elektrische Strom zur Stromversorgung des zweiten Peltier-Elements 15 oder eines gegebenenfalls ersatzweise dafür vorgesehenen Gebläses eingesetzt. Darüber hinaus könnte auch zusätzlich vorgesehen sein, dass das Bedienmodul 9 mit elektrischer Energie, die vom ersten Peltier-Element 13 erzeugt ist, direkt versorgt wird.

### Bezugszeichenliste

- 1: Backofen
- 2: Garraum
- 3: Muffel
- 4: Decke
- 5: Rückwand
- 6: Boden
- 7: Beschickungsöffnung
- 8: Tür
- 9: Bedienmodul
- 10: Bedienelemente
- 11: Schaltungsträger
- 12: Kühlvorrichtung
- 13, 15: Peltier-Elemente
- 14: Außenseite
- 16: Signalleitungen
- 17: Energierückgewinnungsvorrichtung
- 18: Energiespeicher
- 19: Steuereinheit
- 20: Einrichtung
- N: Energieversorgungsnetz

## Patentansprüche

1. Hausgerät mit einer sich im Betrieb erwärmenden ersten Komponente (3) und einer mit elektrischer Energie zu versorgenden Einrichtung (9, 11, 20), wobei das Hausgerät (1) zur elektrischen Energieversorgung mit einem externen Versorgungsnetz (N) verbunden ist, wobei das Hausgerät (1) eine Energierückgewinnungsvorrichtung (17) aufweist, welche mit der ersten Komponente (3) thermisch gekoppelt ist und zur Umwandlung von Wärme der ersten Komponente (3) in elektrische Energie ausgebildet ist, und mit der Einrichtung (9, 11, 20) elektrisch gekoppelt ist, welcher die elektrische Energie bedarfsabhängig bereitstellbar ist, **dadurch gekennzeichnet, dass** das Hausgerät (1) eine Steuereinheit (19) aufweist, durch welche die Versorgung des Hausgeräts (1) durch das Versorgungsnetz (N) überwacht ist und durch welche die Betriebsart der Energierückgewinnungsvorrichtung (17) steuerbar ist.

2. Hausgerät nach Anspruch 1, **dadurch gekennzeichnet, dass** die Energierückgewinnungsvorrichtung (17) als Notstromvorrichtung ausgebildet ist, durch welche die Einrichtung (9, 11, 20) mit Energie versorgt ist, wenn durch das externe Versorgungsnetz (N) keine oder keine ausreichende Energieversorgung gegeben ist.

3. Hausgerät nach einem der vorhergehenden Ansprüche, **dadurch gekennzeichnet, dass** die Energierückgewinnungsvorrichtung (17) ein erstes Peltier-Element (13) aufweist, welches mit der ersten Komponente (3) kontaktiert ist und zur Umwandlung der Wärme der ersten Komponente (3) in elektrischen Strom betrieben ist.

4. Hausgerät nach einem der vorhergehenden Ansprüche, **dadurch gekennzeichnet, dass** es eine Kühlvorrichtung (12) aufweist, welche mit der ersten Komponente (3) des Hausgeräts (1) thermisch gekoppelt ist und die Kühlvorrichtung (12) zur Umwandlung der Wärme der ersten Komponente (3) in elektrischen Strom und zur Umwandlung des Stroms zur Kühlung einer sich im Betrieb erwärmenden zweiten Komponente (9, 11) ausgebildet ist.

5. Hausgerät nach Anspruch 4, **dadurch gekennzeichnet, dass** die Kühlvorrichtung (12) eine Kühleinheit (15) aufweist, welche durch das Anlegen des elektrischen Stroms zum Kühlen der zweiten Komponente (9, 11) ausgebildet ist.

6. Hausgerät nach Anspruch 5, **dadurch gekennzeichnet, dass** die Kühleinheit ein Kühlluftgebläse ist.

7. Hausgerät nach Anspruch 5, **dadurch gekennzeichnet, dass** die Kühleinheit ein zweites Peltier-Element (15) ist, welches mit der zweiten Komponente (9, 11) kontaktiert ist und welches durch Anlegen des elektrischen Stroms zur Erzeugung einer Temperaturdifferenz ausgebildet ist, durch welche die zweite Komponente (9, 11) kühlbar ist.

8. Hausgerät nach Anspruch 3 und 7, **dadurch gekennzeichnet, dass** die beiden Peltier-Elemente (13, 15) direkt elektrisch verbunden sind.

9. Hausgerät nach einem der vorhergehenden Ansprüche 4 bis 8, **dadurch gekennzeichnet, dass** die Kühlvorrichtung (12) und die Energierückgewinnungsvorrichtung (17) ein funktionell beiden Vorrichtungen zugeordnetes Element, insbesondere das erste Peltier-Element (13), aufweisen, welches zur Umwandlung der Wärme der ersten Komponente (3) in elektrischen Strom ausgebildet ist, wobei der erzeugte Strom abhängig vom Bedarf der zu kühlenden zweiten Komponente (9, 11) und/oder abhängig von Betriebsphasen des Hausgeräts (1) zumindest anteilig der Kühlvorrichtung (12) und/oder zumindest anteilig der Energierückgewinnungsvorrichtung (17) bereitstellbar ist.

10. Hausgerät nach Anspruch 3, **dadurch gekennzeichnet, dass** es ein Backofen (1) ist, welcher als erste Komponente eine Muffel (3) aufweist, wobei das erste Peltier-Element (13) an der Muffel (3), insbesondere außerhalb an einer Muffeldecke (4), angeordnet ist.

11. Hausgerät nach einem der vorhergehenden Ansprüche, **dadurch gekennzeichnet, dass** die Einrichtung (20) und/oder die zu kühlende zweite Komponente (9, 11) ein Bedienmodul (9), insbesondere ein elektronischer Schaltungsträger (11) und/oder ein Motor, ist.

12. Verfahren zum Versorgen einer Einrichtung (9, 11, 20) eines Hausgeräts (1) mit Energie, welches eine sich im Betrieb erwärmende erste Komponente (3) aufweist und das Hausgerät (1) zur elektrischen Energieversorgung mit einem externen Versorgungsnetz (N) verbunden wird, wobei eine Energierückgewinnungsvorrichtung (17) des Hausgeräts (1) mit der ersten Komponente (3) thermisch gekoppelt wird und die Wärme der ersten Komponente (3) durch die Energierückgewinnungsvorrichtung (17) in elektrische Energie umgewandelt wird, wobei die Energierückgewinnungsvorrichtung (17) mit der Einrichtung (9, 11, 20) elektrisch gekoppelt wird, und die elektrische Energie der
Einrichtung (9, 11, 20) bedarfsabhängig bereitgestellt wird, **dadurch gekennzeichnet, dass** die Energieversorgung des Hausgeräts (1) durch das Versorgungsnetz (N) durch eine Steuereinheit (19) überwacht wird und die Betriebsart der Energierückgewinnungsvorrichtung (17) und die bedarfsabhängige Energiebereitstellung der Energieversorgungseinrichtung (17) durch die Steuereinheit (19) gesteuert wird.

13. Verfahren nach Anspruch 12, **dadurch gekennzeichnet, dass** die Energierückgewinnungsvorrichtung (17) als Notstromvorrichtung betrieben wird, durch welche die Einrichtung (9, 11, 20) mit Energie versorgt wird, wenn durch das externe Versorgungsnetz (N) keine oder keine ausreichende Energieversorgung erreicht wird.

## Claims

1. Domestic appliance with a first component (3) that heats up during operation and a device (9, 11, 20) to be supplied with electrical energy, wherein the domestic appliance (1) is linked for its electrical energy supply to an external power supply network (N), wherein the domestic appliance (1) has an energy recovery device (17) which is thermally coupled to the first component (3) and is embodied for conversion of heat of the first component (3) into electrical energy, and is electrically coupled to the device (9, 11, 20) to which the electrical energy is able to be supplied depending on demand, **characterised in that** the domestic appliance (1) has a control unit (19) through which the supply of power to the domestic appliance (1) by the power supply network (N) is monitored and through which the mode of operation of the energy recovery device (17) is able to be controlled.

2. Domestic appliance according to claim 1, **characterised in that** the energy recovery device (17) is embodied as an emergency power device through which the device (9, 11, 20) is supplied with energy when no power or insufficient power is being supplied by the external power supply network (N).

3. Domestic appliance according to one of the preceding claims, **characterised in that** the energy recovery device (17) has a first Peltier element (13) which is in contact with the first component (3) and is operated for converting the heat of the first component (3) into electrical current.

4. Domestic appliance according to one of the preceding claims, **characterised in that** it has a cooling device (12) which is thermally coupled to the first component (3) of the domestic appliance (1) and the cooling device (12) is embodied for conversion of heat of the first component (3) into electrical current and for conversion of the current for cooling a second component (9, 11) which heats up during operation.

5. Domestic appliance according to claim 4, **characterised in that** the cooling device (12) has a cooling unit (15) which is embodied, by the application of the electrical current, for cooling the second component (9, 11).

6. Domestic appliance according to claim 5, **characterised in that** the cooling unit is a cooling air blower.

7. Domestic appliance according to claim 5, **characterised in that** the cooling unit is a second Peltier element (15) which is in contact with the second component (9, 11) and which, by application of the electrical current, is embodied for creating a temperature difference through which the second component (9, 11) is able to be cooled.

8. Domestic appliance according to claim 3 and 7, **characterised in that** the two Peltier elements (13, 15) are directly electrically connected.

9. Domestic appliance according to one of the preceding claims 4 to 8, **characterised in that** the cooling device (12) and the energy recovery device (17) have an element functionally assigned to the two devices, especially the first Peltier element (13), which is embodied for conversion of the heat of the first component (3) into electrical current, wherein the created current is able to be provided depending on demand to the second component to be cooled (9, 11) and/or depending on operating phases of the domestic appliance (1), at least in part to the cooling device (12) and/or at least in part to the energy recovery device (17).

10. Domestic appliance according to claim 3, **characterized in that** it is a baking oven (1) which has a muffle (3) as its first component, wherein the first Peltier element (13) is disposed on the muffle (3), especially outside on a muffle cover (4).

11. Domestic appliance according to one of the preceding claims, **characterised in that** the device (20) and/or the second component (9, 11) to be cooled is an operating module (9), especially an electronic circuit carrier (11) and/or a motor.

12. Method for supplying energy to a device (9, 11, 20) of a domestic appliance (1) which has a first component (3) which heats up during operation and the domestic appliance (1) is connected for supply of its electrical energy to an external power supply network (N), wherein an energy recovery device (17) of the domestic appliance (1) is thermally coupled to the first component (3) and the heat of the first component (3) is converted by the energy recovery device (17) into electrical energy, wherein the energy recovery device (17) is electrically coupled to the device (9, 11, 20) and the electrical energy is provided to the device (9, 11, 20) depending on demand, **characterised in that** the supply of energy to the domestic appliance (1) by the power supply network (N) is monitored by a control unit (19) and the mode of operation of the energy recovery device (17) and the demand-dependent energy provision of the energy supply device (17) is controlled by the control unit (19).

13. Method according to claim 12, **characterised in that** the energy recovery device (17) is embodied as an emergency power device, through which the device (9, 11, 20) is supplied with energy when no power or insufficient power is being supplied by the external power supply network (N).

## Revendications

1. Appareil ménager comprenant un premier composant (3) chauffant en cours de fonctionnement et un dispositif (9, 11, 20) à alimenter en énergie électrique, où l'appareil ménager (1) est connecté à un réseau d'alimentation (N) externe pour l'alimentation en énergie électrique, où l'appareil ménager (1) présente un dispositif de récupération de l'énergie (17) qui est couplé thermiquement au premier composant (3) et est conçu pour la transformation de la chaleur du premier composant (3), en énergie électrique, et est couplé électriquement au dispositif (9, 11, 20) auquel l'énergie électrique peut être fournie en fonction des besoins,
**caractérisé en ce que** l'appareil ménager (1) présente une unité de commande (19) par laquelle est contrôlée l'alimentation de l'appareil ménager (1) assurée par le réseau d'alimentation (N) et par laquelle peut être piloté le mode de fonctionnement du dispositif de récupération de l'énergie (17).

2. Appareil ménager selon la revendication 1, **caractérisé en ce que** le dispositif de récupération de l'énergie (17) est conçu comme un dispositif d'alimentation électrique de secours par lequel le dispositif (9, 11, 20) est alimenté en énergie quand le réseau d'alimentation (N) externe ne fournit aucune alimentation en énergie ni une alimentation suffisante.

3. Appareil ménager selon l'une quelconque des revendications précédentes, **caractérisé en ce que** le dispositif de récupération de l'énergie (17) présente un premier élément Peltier (13) qui est en contact avec le premier composant (3) et est actionné pour la transformation de la chaleur du premier composant (3), en courant électrique.

4. Appareil ménager selon l'une quelconque des revendications précédentes, **caractérisé en ce qu'**il présente un dispositif de refroidissement (12) qui est couplé thermiquement au premier composant (3) de l'appareil ménager (1), le dispositif de refroidissement (12) étant conçu pour la transformation de la chaleur du premier composant (3), en courant électrique, et pour la transformation du courant servant au refroidissement d'un deuxième composant (9, 11) chauffant en cours de fonctionnement.

5. Appareil ménager selon la revendication 4, **caractérisé en ce que** le dispositif de refroidissement (12) présente une unité de refroidissement (15) qui est conçue pour le refroidissement du deuxième composant (9, 11), par l'application du courant électrique.

6. Appareil ménager selon la revendication 5, **caractérisé en ce que** l'unité de refroidissement est une soufflante d'air de refroidissement.

7. Appareil ménager selon la revendication 5, **caractérisé en ce que** l'unité de refroidissement est un deuxième élément Peltier (15) qui est en contact avec le deuxième composant (9, 11) et qui est conçu pour la production d'une différence de température par l'application du courant électrique, différence de température par laquelle peut être refroidi le deuxième composant (9, 11).

8. Appareil ménager selon les revendications 3 et 7, **caractérisé en ce que** les deux éléments Peltier (13, 15) sont connectés électriquement de façon directe.

9. Appareil ménager selon l'une quelconque des revendications précédentes 4 à 8, **caractérisé en ce que** le dispositif de refroidissement (12) et le dispositif de récupération de l'énergie (17) présentent un élément, en particulier le premier élément Peltier (13), associé fonctionnellement aux deux dispositifs, élément qui est conçu pour la transformation de la chaleur du premier composant (3), en courant électrique, où le courant produit peut être fourni en fonction des besoins du deuxième composant (9, 11) à refroidir et/ou en fonction de phases de fonctionnement de l'appareil ménager (1), au moins celles relatives au dispositif de refroidissement (12) et/ou au moins celles relatives au dispositif de récupération de l'énergie (17).

10. Appareil ménager selon la revendication 3, **caractérisé en ce que** c'est un four de cuisson (1) qui présente un moufle (3) comme premier composant, où le premier élément Peltier (13) est disposé sur le moufle (3), en particulier à l'extérieur sur un plafond de moufle (4).

11. Appareil ménager selon l'une quelconque des revendications précédentes, **caractérisé en ce que** le dispositif (20) et/ou le deuxième composant (9, 11) à refroidir est un module de fonctionnement (9), en particulier un support de circuit électronique (11) et/ou un moteur.

12. Procédé servant à l'alimentation en énergie d'un dispositif (9, 11, 20) d'un appareil ménager (1) qui présente un premier composant (3) chauffant en cours de fonctionnement, l'appareil ménager (1) étant connecté à un réseau d'alimentation (N) externe, pour l'alimentation en énergie électrique, où un dispositif de récupération de l'énergie (17) de l'appareil ménager (1) est couplé thermiquement au premier composant (3), et la chaleur du premier composant (3) est transformée en énergie électrique, par le dispositif de récupération de l'énergie (17), où le dispositif de récupération de l'énergie (17) est couplé électriquement au dispositif (9, 11, 20), et l'énergie électrique du dispositif (9, 11, 20) est fournie en fonction des besoins, **caractérisé en ce que** l'alimentation en énergie de l'appareil ménager (1), fournie par le réseau d'alimentation (N), est contrôlée par une unité de commande (19), et le mode de fonctionnement du dispositif de récupération de l'énergie (17) et la fourniture d'énergie - en fonction des besoins - du dispositif de récupération de l'énergie (17) sont commandés par l'unité de commande (19).

13. Procédé selon la revendication 12, **caractérisé en ce que** le dispositif de récupération de l'énergie (17) est actionné comme un dispositif d'alimentation électrique de secours par lequel le dispositif (9, 11, 20) est alimenté en énergie, quand le réseau d'alimentation (N) externe ne fournit aucune alimentation en énergie ni une alimentation suffisante.
